# EUROPEAN PATENT APPLICATION

(11) **EP 0 550 358 A2**
(43) Date of publication of application: **07.07.1993**
(21) Application number: 92420481.1
(22) Date of filing: 23.12.1992
(51) Int. Cl.: G06F 9/46, G06F 15/16, G06F 11/00, G06F 11/18

(54) **Fault tolerant multiprocessor cluster**

(30) Priority: 30.12.1991 US 813752
(71) Applicant: ATEX PUBLISHING SYSTEMS CORPORATION, Bedford, Massachusetts 07130 (US)
(72) Inventor: Vinther, Gordon A., c/o EASTMAN KODAK COMPANY, Rochester, New York 14650-2201 (US); Brudevold, Finn, c/o EASTMAN KODAK COMPANY, Rochester, New York 14650-2201 (US)
(74) Representative: Schoppe, Fritz, Dipl.-Ing.

(57) **Abstract**

The present invention is a system that provides a shared, common memory unit for multiple computers accessing the same database in a multiprocessor transaction type computer network. The memory unit acts as a common repository for the multiple computers and which store data and system state. A bus interface is provided for each computer which allows each computer to be located remotely of the common memory unit. The bus interface allows each computer to write into triplicated memories simultaneously. The interface ensures that the data read out of the memory is correct by voting on the memory outputs and passing to the corresponding computer only the correct data. The system is also provided with fault tolerant clock signals for keeping the triplicated memories operating in synchronism. This along with appropriate software make the group of computers immune to any single point of failure.

## Description

### BACKGROUND OF THE INVENTION

### Field of the Invention

The present invention is directed to the creation of a fault tolerant multiprocessor system using commercially available computer systems and, more particularly, to a system in which standard computer systems can be combined into a fault tolerant multiprocessor cluster by interconnecting the computers to a fault tolerant shared memory. The shared memory being fault tolerant will confer fault tolerance to the whole cluster of processors. The fault tolerant shared memory system also provides interprocessor interrupts and atomic semaphore generation. The memory, interprocessor interrupts and semaphores are made fault tolerant by triplicating each functional element and requiring that at least two elements agree during each operation.

### Description of the Related Art

### Fault Tolerant System Requirements

Three operations are required to implement fault tolerance in a multiprocessing system. First, a system of locks to guarantee exclusive access to shared data and system resources. Second, a means for producing a fault tolerant copy of the database. Third, a journalling mechanism to record database transaction input data and processing requirements.

### a. Shared Fault Tolerant Lock Requirements

Systems with multiple processes running simultaneously and writing to a common set of data items require some mechanism to enforce exclusive access to the various data, program and hardware resources of the group of processors. A software setable and clearable semaphore (a lock), in memory, visible to all processors is one way of providing this exclusive access. The hardware of a fault tolerant memory, such as in the present invention, manages the memory to provide a unique response to the first reader of or machine executing a read access of an unlocked semaphore location.

Intimate shared access to a semaphore, such as occurs in the present invention, has significant benefits in a multiprocessor environment. Shared semaphores allow all processors to participate in lock management. Without shared semaphores the processors typically negotiate with a single processor for semaphore related permissions. These negotiation processes add overhead to the memory lock acquisition process. Database management systems are required to handle a large volume of small transactions and each data change transaction will require one or more exclusive access permissions. Lock management can become a limiting factor in a multiprocessor system.

### b. Guaranteed Data Availability

Fault tolerancy requires that data and state information be available in the event of any single point of failure.

Fault tolerant systems provide protection against loss of access to the data by copying the data to a second location. A fault tolerant memory, such as in the present invention, offers two possibilities for protecting the data against the failure of a single system.

The data in a fault tolerant memory, such as in the present invention, is guaranteed to be available. All functioning processors can read and write the data. If the fault tolerant memory, as in the present invention, is large enough to support the largest amount of data created then simply writing the data to the memory is sufficient to guarantee access. However if the data storage requirements exceed the cost, size and performance tradeoffs, the fault tolerant shared memory, as in the present invention, can be used as a temporary storage buffer. The buffer contents would be periodically copied to two or more separate systems in the cluster. A processor which writes data to the fault tolerant memory can feel confident that data will be accessible to another processor. The sending processor does not have to wait for an acknowledgement activity which is a significant performance improvement offered by shared memory systems, such as in the present invention.

### c. Journal Copy

This is a special case of fault tolerant memory data storage. Journals are used to record the type and content of transactions to be applied against the database. The use of journals allows a processor other than the one performing the database update to redo the update if the processor performing the update fails. The fault tolerant shared memory guarantees that journal data written to the memory will be accessible to other processors if the writer or processor executing a write access should fail. No acknowledgement is required.

### Description of the Prior Art

### Vax clusters

Digital Equipment Corporation VAX Clusters provide fault tolerance with standard processors. A high speed network provides the interconnect between the processors. One processor is responsible for providing lock permissions to all the other processors in the cluster. Lock overhead is high compared with shared memory due to the lack of intimate access to the lock resource by the processor requiring lock access.

### Status/Tandem

Both Stratus Computer Inc. of Marlborough, Massachusetts and Tandem Computers, Inc. of Cupertino, California are able to enjoy the performance benefits of shared memory in a multiprocessor configuration. In these systems fault tolerance relies on unique hardware for each element of the system. The total system cost will be higher than for a system requiring specialized hardware only in the area of shared memory.

### SUMMARY OF THE INVENTION

It is an object of the present invention to provide a fault tolerant multiprocessor cluster using commodity type commercially available components and a specialized interface.

It is another object of the present invention to provide a system that corrects faults.

It is also an object of the present invention to guarantee access to the fault tolerant memory by all processors but one in the event of any failure.

It is a further object of the present invention to provide a system that votes on memory outputs.

It is an additional object of the present invention to provide a system that has a fault tolerant clock.

It is another object of the present invention to provide atomic semaphore capability for the memory such that only a memory read is required to establish a set semaphore.

It is also an object of the present invention to allow a processor attached to shared memory to interrupt another processor attached to the same shared memory.

The above objects can be attained by a system that provides a common I/O bus interface for each computer to a common fault tolerant, shared memory. The invention allows each computer to not only write into triplicated memories simultaneously, but also ensures that the data read out of the shared memory is correct by voting on the memory outputs and passing to the requesting computer only the correct data. Triplicated interrupts passed between computers are also voted on to ensure interrupt integrity. The system is also provided with the fault tolerant clock signals for keeping the triplicated memories operating in synchronism.

These together with other objects and advantages which will be subsequently apparent, reside in the details of construction and operation as more fully hereinafter described and claimed, reference being had to the.accompanying drawings forming a part hereof, wherein like numerals refer to like parts throughout.

### BRIEF DESCRIPTION OF THE DRAWINGS

Fig. 1 illustrates the components of the present invention;
Figs. 2a-2d illustrate the registers used in the present invention;
Fig. 3 illustrates the fault tolerant clock of the service module of Fig. 1;
Fig. 4 illustrates the details of the host processor interface 30 of Fig. 1;
Figs. 5-8 illustrate the states and the signal timing of the interface 30;
Fig. 9 illustrates the details of the remote processor interface 32 of Fig. 1; and
Figs. 10 and 11 illustrate the voting mechanisms of the present invention;
Fig. 12 illustrates the read states of the interface 32;
Fig. 13 illustrates the clock circuit for writes in the interface 32; and
Fig. 14 illustrates the write states of processor 32.

### DESCRIPTION OF THE PREFERRED EMBODIMENTS

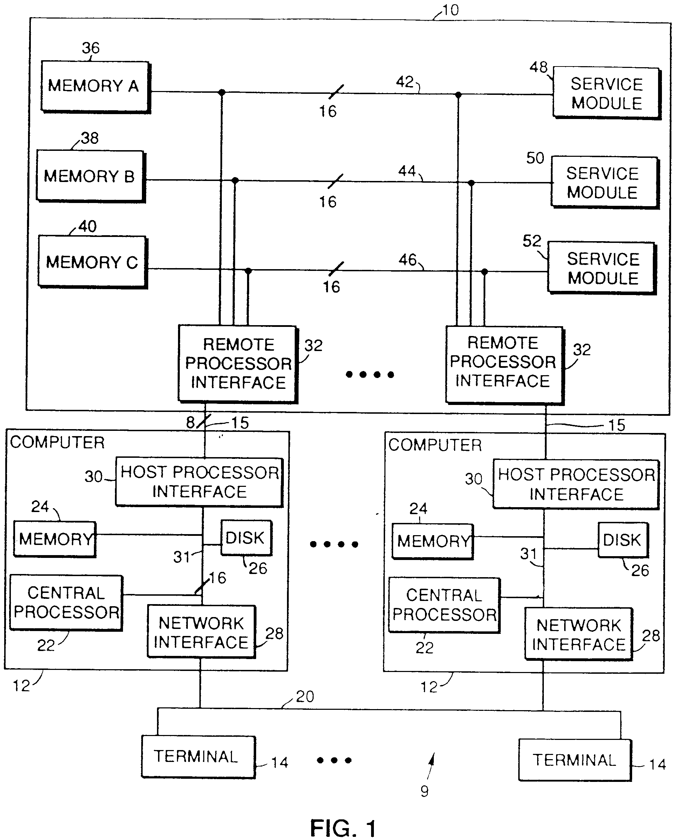

The present invention 9, as illustrated in Fig. 1 includes a common memory unit 10 connected to and shared by a plurality of computers 12 serving multiple users. The common memory unit 10 acts as a fault tolerant repository of data that is to be commonly accessible by the computer 12 comprising the multiprocessor cluster. Information stored in this repository can be retrieved without error even in the case of a single point failure in the above fault tolerant repository. The computers 12 are connected to the common memory unit 10 by multipair wire cables 15 or an optical fiber communications link with appropriate serial interface circuits. The computers 12, which act as file servers or database servers for computers/terminals 14, are also connected to each other and the terminals 14 over a conventional communication network 20, such as an ETHERNET. Each of the computers 12 is a processor generally available in the industry, preferably a commodity type off the shelf computer, such as an IBM AT or equivalent clone. Each of the computers 12 includes a central processor 22, memory 24, disk 26 and a network interface 28 along with appropriate conventional software which will allow a process to communicate with other processes at other computers 14 over the network 20. Database systems such as INGRES available from Relational Technology Inc. of Alameda, California or SYBASE available from Sybase Corp., Emeryville, California are database software packages that can execute in computers 12. These database software packages require modification to realize the full benefits of the fault tolerant shared memory. They currently operate in multiprocessor environments and support commit and rollback functions. Relatively little modification related to storing data and system state in the fault tolerant memory rather than in a disk memory, which can be accomplished by those of ordinary skill in the database server art, is required to integrate them into the fault tolerant shared memory environment and to thereby create a high performance fault tolerance multiprocessor cluster once the present invention is understood.

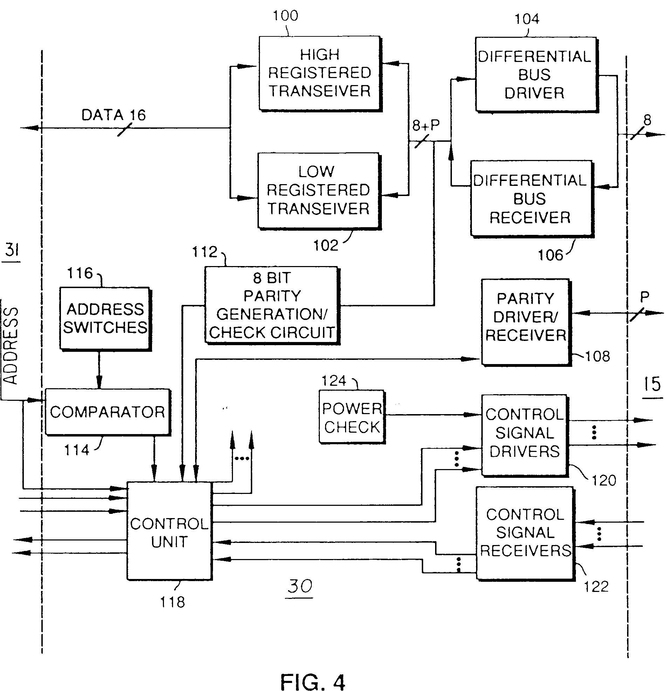

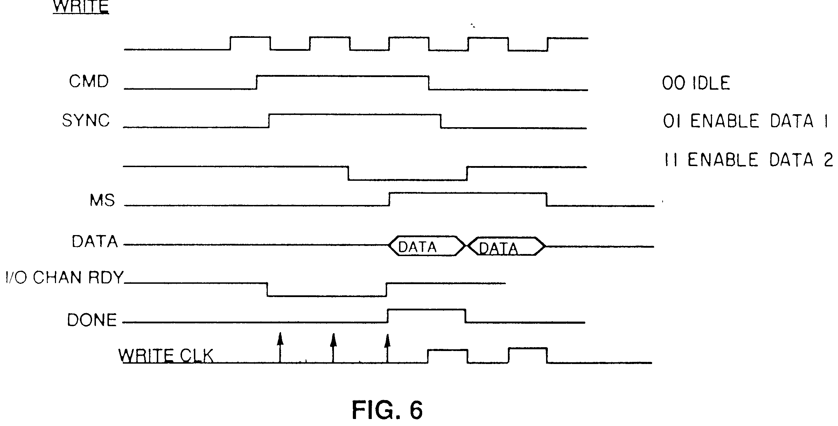

Each computer 12 treats the common memory unit 10 as a conventionally addressable device through a host processor interface 30 which will be discussed in more detail with respect to Fig. 4 and which is connected to a conventional internal bus 31 of the computer 12. The host processor interface 30 is connected to a remote processor interface 32 included within the common memory unit 10. The details of the remote processor interface 32 will be discussed with respect to Fig. 6. The remote processor interface 32 is connected to three separate bus systems 42, 44, and 46 and during write transactions will write the data simultaneously to three memories 36, 38 and 40. During read transactions all three memories will be read simultaneously and data from memories which match are returned by the remote processor interface 32 to the host processor interface 30.

The buses 40, 42 and 44 of the multiple-bus system are Multibus II compatible per ANSI/IEEE standard 1296-1987. The Multibus II is a synchronous bus and supplies fair arbitration of multiple bus requests.

It is preferable that the memory system be of large capacity. The more data that can be deposited into the fault tolerant memory the less that will have to be copied into local disks 26. The memory could be hundreds of megabytes in size. Cost performance tradeoffs are the deciding factor.

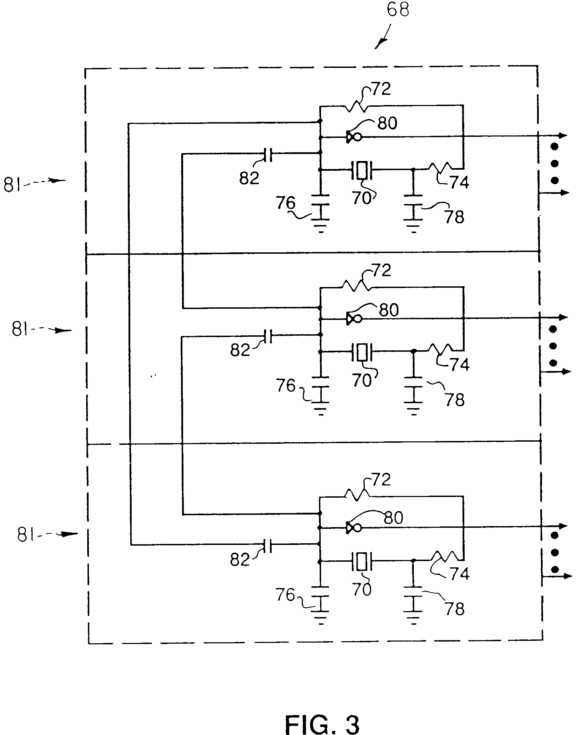

The service modules 48, 50 and 52 provide timing and control signals for the buses 42, 44 and 46 and for the memories 36, 38 and 40. These service modules which include synchronous external memory refresh logic for memory modules 36, 38 and 40, except for the fault tolerant clock therein, are conventional modules used in Multibus II systems. The details of the fault tolerant clock within the service modules 48, 50 and 52 will be discussed with respect to Fig. 3. The system illustrated in Fig. 1, using the conventional components discussed herein and the interface devices also discussed herein is capable of linking up to 20 computers 12 to each other. Each computer 12 can service many terminals 14.

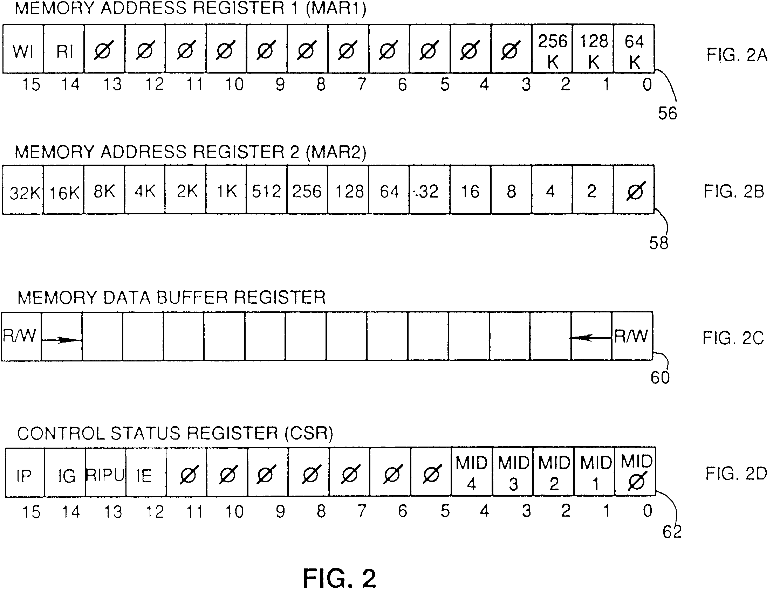

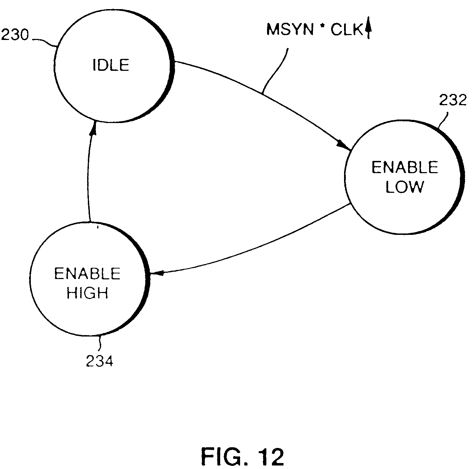

The operation of the fault tolerant shared memory occurs and is controlled through four registers and their associated function sets. Figs. 2a-2d show the four registers 56, 58, 60 and 62 which provide the interface to the fault tolerant memory in each computer 12. The registers 56-62 exist in the I/O address space of computer 12. The registers are addressed using nnn0 for the control and status register 62, nnn2 for the second memory address register 58, nnn4 for the first memory address register 56, and nnn6 for the memory data buffer register 60. The memory address registers 56 and 58 of Figs. 2a and 2b supply the memory address to be accessed when reading or writing the content memory data buffer register 60 to and from the memories 36, 38 or 40. Bit 15, when set, indicates that the address stored in these registers 56 and 58 is incremented every time the memory data buffer register 60 is written. Bit 14 provides the same indication with respect to read operations. Bits 13-0 store the high order address of the desired memory address in memories 36-40. Bits 15-0 of the memory address register 58 store the low order memory address bits. The memory data buffer register 60 of Fig. 2c, when read or written, by computer 12, initiates read or write operations to the triplicated fault tolerant memory (memories 36-40) and stores the data transferred between the computer 12 and the fault tolerant memory. Semaphore reads and writes are read or written to the addresses in fault tolerant memory where the address is less that the address specified in the control and status register 62 bits 5 and 6 as illustrated in Fig. 2d. Bits 5 and 6 specify an address of 4, 8, 16 or 32 thousand for the locations of semaphores. For example, if bits 5 and 6 in register 62 are set to indicate the four thousands locations, then any read of the data buffer register 60 where the memory address register 56 and 58 contains an address less than 4 thousand will be a semaphore operation. A read of a semaphore location will return zero, in bit 15 of the data, to the reader (the computer 12 checking the semaphore) if the location has a zero in bit 15 of buffer register 58. Invisible to the reader the corresponding memory location bit 15 will be set to a one following a read of zero as discussed with respect to Fig. 12. All other readers of this semaphore will see a one. It is the responsibility of the reader who reads a zero to clear the bit when he is done with the semaphore.

The control and status register 62 is used to specify various operations as detailed in Fig. 2d. Interprocessor interrupts are performed by writing into bits 0-4 of the control and status register 62 a number (a machine ID) representing the computer 12 the interrupt is directed to and by writing a one to bit 14 the interrupt go bit. Bit 15, when set, indicates that an interrupt has been directed at this machine. Bit 13 is set whenever the remote processor interface 32 is powered up and initialized. Bit 12 is the enable interrupt bit which allows this machine to be interrupted when set. Bits 11-6 are unused.

The fault tolerant clock 68, as illustrated in Fig. 3, consists of three separate clock circuits 81 which are immune to any single point of failure. Conventional oscillator circuit components are coupled together through feedback capacitors 82 such that the clock circuits 81 oscillate in synchronism with each other. The capacitors also prevent backplane shorts from damaging the clock circuits 81. During operation the fastest oscillator circuit pulls the other oscillator circuits along. The clock circuits 81 include a conventional crystal 70 along with conventional resistor, capacitor and invertor elements 72-80 necessary to create the three crystal based oscillator circuits 81. A substitute for the fault tolerant clock circuit of Fig. 3 is described in U.S. Patent 4,644,498. This patent also describes synchronous counters and logic that can be used to trigger synchronous memory refresh when dynamic RAM is used in memories 36, 38 and 40.

The host processor interface 30, as illustrated in Fig. 4, includes bi-directional registered transceivers 100 and 102 providing 16 bit data storage for data being manipulated to and from the differential bus 15. The registered transceivers 100 and 102 are conventional devices such as 74F646. When receiving data from the remote processor interface 32 a conventional differential bus receiver 106, connected to the cable 15, places alternate eight bit words at the input of the registered transceivers 100 and 102. The received bytes are strobed into one transceiver or the other forming a 16 bit word to be sent to an ISA/AT type bus 31 in computer 12. When sending data from the bus 31 to the remote processor interface 32, registered transceivers 100 and 102 hold the bus data while alternately supplying eight bit data to conventional differential bus driver 104 for transmission. Parity P is generated and checked for each 8 bits of data on the differential bus 15. The parity is determined by a parity circuit 112 which can be, for example, 74F280 parity check circuits. Whenever the computer 12 transfers data to the memory unit 10, the computer 12 addresses the host processor interface 30 through a conventional address comparator 114 which compares the higher order bits of the address on the bus 31 to the address for the interface 30 set in address switches 116. The low order bits indicate which of the data and address registers 56-62 are being addressed. When the comparator 114 indicates to the control unit 118 that the host processor interface 30 is being addressed, the control unit 118, which is essentially a finite state machine that moves through various states, depending on its input signals, produces the appropriate control signals for the circuits 100, 102, 104, 106 and 108. The output control signals are transferred to the cable 15 through control signal drivers 120 and input control signals from the cable 15 are supplied to the control unit 118 through control signal receivers 112. These conventional differential driver and receivers are of the type 75172 and 75173 and provide all bus signals. One of the control signals transferred to the cable 15 is produced by a power check circuit 124 which outputs a signal whenever the host processor interface 30 is powered up. A signal from the remote processor interface 32 indicates to the host processor 30 that the remote processor interface 32 is powered up and initialized and is also provided to the control unit 118. Among the signals received by the control unit 118 from the bus 31 are I/O read and I/O write signals. The control unit 118 provides the io-chan-rdy signal to the ISA bus until the I/O function is done. The control unit 118 sends-A1,A2,MS,RD/WRT signals, which will be discussed later, to the remote processor interface 32 in addition to the powered up signal previously mentioned. The remote processor interface 32 sends to the control unit 118 control signals RUP (Remote powered Up), WAIT, CLK (a 10 mhz synchronous clock) and Dint(Data Interrupt) signals.

The host processor interface functions are defined as either a read or write. The read or write operation is limited to four addresses. The addresses are specified to the remote processor interface 32 by A1 and A2 which are simply passed from the ISA bus 31 address bus sections SA1 and SA2. The function specification to the remote processor interface 32 of the read or write is a pass through of the I/O read signal or I/O write signal of bus 31. The control unit 118 of the host processor interface runs off the 10 Mhz clock originating from the fault tolerant clock 48, 50, and 68.

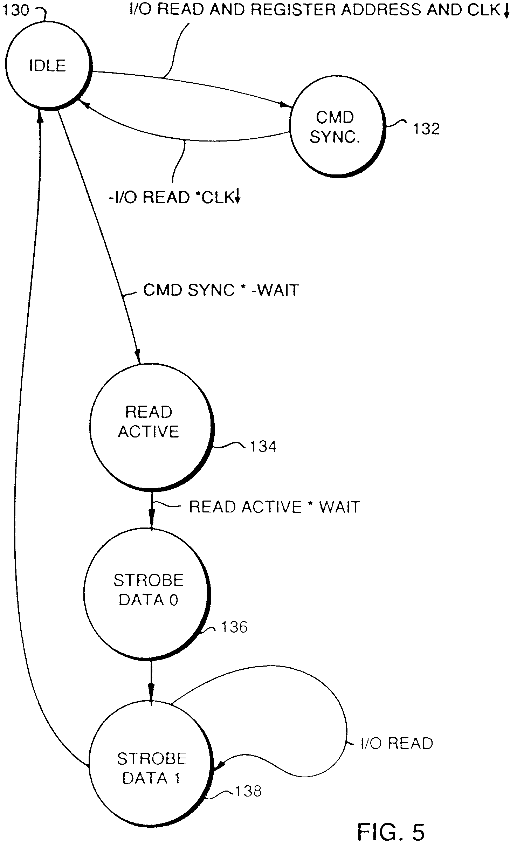

An I/O read from the ISA bus starts when the I/O read signal exists and the address bits SA2-SA9 of bus 31 are equal to the address of one of the four registers 56,58 , 60 and 62 of Fig. 2, as detected by comparator 114. The start is clocked on the falling clock edge of the clock signal and the system leaves the idle state 130 and enters the CMD SYNC state 132 as illustrated in Figs. 5 and 6. The rising clock edge of the clock signal from the fault tolerant clock of Fig. 3 initiates all state changes to allow for possible metastable states in Cmd Sync. ISA bus I/O_Chan_Rdy is negated on ISA address confirmation and I/O Read. I/O_Chan_Rdy is asserted when Strobe Data 1 is set 138. This holds off the ISA bus 31 until the read data is fully assembled. Read Active 134 is set when Cmd Sync is set and Wait from the host processor interface 30 is negated by the control unit 118. The remote processor interface 32 asserts Wait to hold off cycles from the host processor interface 30 until it is ready for a new transaction. The Wait signal is synchronous with the Clk (clock) signal and changes state with the clock negative edge. The assertion of Read Active asserts Master Sync which triggers a sequence generator cycle in the remote processor interface 32. When the sequence generator of the remote processor interface 32 has the data available it places alternate bytes on the cable 15 in phase with the Wait signal. The sequence generator asserts Wait along with the first data byte. The host processor interface 30 enters the Strobe Data 0 state 136 and clocks the low byte into the low registered transceiver 102. The next clock causes a transition to the Strobe Data 1 state 138 which clocks the high byte into the high registered transceiver 100 . Strobe Data 1 is held set until central processor 22 negates I/O Read at which point the control unit 118 returns the host processor interface to the idle state 130. The Strobe Data 1 state 138 allows the assertion of I/O_Chan_Rdy thus signaling the central processor 22 to take the data. Note that when parity is violated by the read data the I/O_Chan_Chk is asserted by the control unit 118 on the bus 31 and the computer 12 addresses this issue by stopping and removing itself from the system.

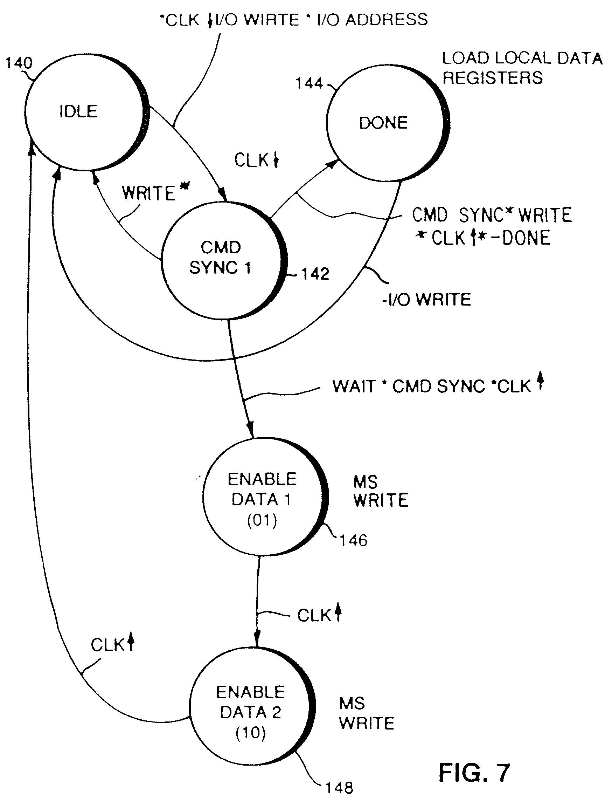

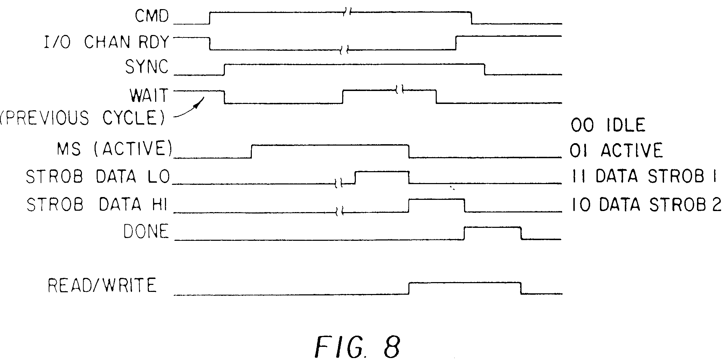

Writes are initiated when the central processor 22 writes to one of the four registers 56, 58, 60 and 62 in its I/O space. Write data is written as sixteen bits into the high registered transceiver 100 and the low registered transceiver 102 where it is held until it can be passed to the remote processor interface 32. The data is passed to the remote processor interface 32 as two eight bit bytes over cable 15. The transfer of the data to memory 36, 38 and 40 takes longer than the acknowledgement given to computer 22. Done will be signalled to the central processor 12 as soon as the data is loaded into the registered transceivers 100 and 102. Figs. 7 and 8 illustrate the control flow for a host processor write. From the idle state 140 the Cmd Sync state 142 of the control unit 118 sets on detection of an I/O write signal and an I/O address equal to one of the four interface registers of Figs. 2a-2d. The Done state 144 sets on the next positive clock edge. Done setting loads the data into transceivers 100 and 102. The setting of the Enable Data 1 state 146, which occurs when nonwait, command sync and a rising clock edge exist, generates Master Sync which tells the remote processor interface 32 that a command is available. The remote processor interface 32 sets Wait in response to hold off any further cycles until the specified operation is finished. The Enable Data 2 state 148 follows on the next clock. Idle 142 follows on the next clock. The sixteen bit data word is gated alternately from the registered transceivers 100 and 102 to the differential bus driver 104 to the cable 15 on control to the two enable data states 146 and 148.

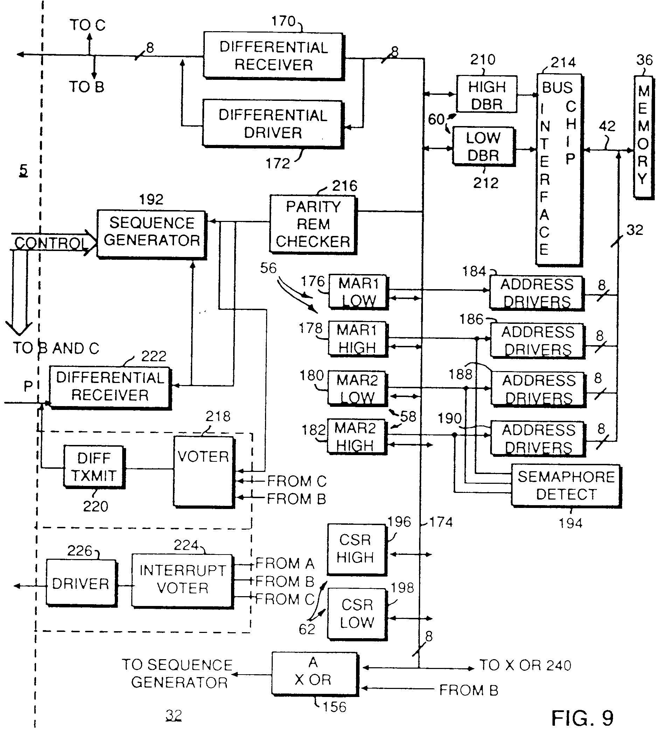

The remote processor interface 32 connects the host processor interface 30 to the three memories 36, 38 and 40. It manages the memories to produce a single image of the memory data and corrects for any memory error. The remote processor interface 32 consists of three circuits of the type illustrated in Fig. 9 and for the purposes of simplicity only one of the three circuits is shown in Fig. 9. Each of the three versions of Fig. 9 interface to one of the three Multibus II busses 42, 44 and 46 and to one of the memories 36, 38 and 40. On writes to a memory location all three memories 36, 38 and 40 will be written with the same data at the same time. During a read of the memory data all three memories 36, 38 and 40 will be read at the same time and the remote processor interface 32 will select the data from the memories which agree and return that data to the computer 12.

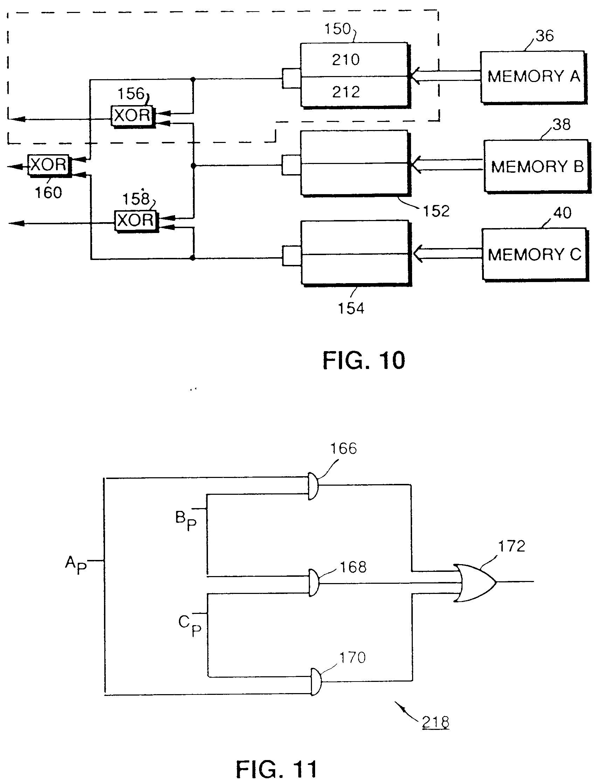

Multibit data voting occurs in the remote processor interface 32 whenever data is transferred from the memories 36, 38 and 40 to the computer 12 as illustrated in Fig. 10. The dashed line in Fig. 10 outlines a portion of the remote processor interface 32 which will be discussed in detail. The output data from memories 36, 38 and 40 is transferred to storage registers 150, 152 and 154 in corresponding sections of the remote processor interface 32. These storage registers correspond to the memory data buffer registers found in the interface 32 illustrated in Fig. 9 as registers 210 and 212. The registers 150 and 152 and their counterparts on the duplicates of Fig. 9 apply the stored data to the conventional 8 bit Exclusive Or circuits 156, 158 and 160. If the outputs of registers 150 and 152 are equal the Exclusive Or circuit 156 outputs a coincidence signal indicating that a match has occurred. If the outputs of the registers 150 and 152 do not match, the Exclusive Or circuit 156 does not produce an output. The same coincidence test occurs between the outputs of registers 152 and 154 by the Exclusive Or circuit 158 and for the outputs of registers 150 and 154 by Exclusive Or circuit 160. As will be discussed in more detail with respect to Fig. 9, the output produced by the remote processor interface 32 and transferred to the host processor interface 30 is governed by the signals indicating coincidence of the outputs from the memories 36, 38 and 40.

The circuit for performing single bit parity voting for the data and for interrupts is shown in Fig. 11. This voter includes three And gates 166, 168 and 170 and an Or gate 172.

The data paths of the remote processor interface 32 are illustrated in Fig. 9. The remote processor interface 32 includes a conventional differential receiver 170 which is used to transfer data from the cable 15 to an internal data bus 174. Conventional differential transmitter 172 transfers data from the internal data bus 174 to the cable 15.

The memory address registers 176, 178, 180 and 182 are provided to specify the location in memory 34 where the data is either retrieved from or stored. The memory address registers 176, 178, 180 and 182, as discussed in the Fig. 2a discussion, also act as registers with increment capability. The memory address registers are loaded when the CPU writes to address nnn2, nnn4. The memory address register contents are driven onto bus 42 by bus drivers 184, 186, 188 and 190 when a memory read or write is commanded by a data buffer register access and at a time determined by the multibus interface chip 214. The memory address register is incremented at the end of a read or write if the Read Increment bit (bit 14) or Write Increment bit (bit 15) is set in the memory address register 176 and 178.

The control and status registers 196 and 198 implement the various control functions discussed with respect to Fig. 2d. They are written and read by CPU 12 by references to their I/O address.

The data registers 210 and 212 are conventional bidirectional registered transceivers and provide eight to 16 bit conversion and storage of data words to and from the memory 36 through a conventional Multibus II control chip 214. The process of writing or reading the data buffer registers 210 and 212 at their I/O address by CPU 12 initiates a corresponding memory 36, 38 and 40 read or write.

Conventional parity generator 216 generates or checks parity for all data on internal bus 174. The generator 216 drives one input to voter 218 to supply parity for data on cable 15. The voter 218 is not repeated on the two other parts of the remote processor interface 32. The parity generator 216 also generates parity for data received from cable 15. If a parity error is detected in the received data, the sequence generator 192 will abort the transaction and can set a status register bit indicating such.

If the sequence generator 192 has received the match signal from the Exclusive Or circuit 156, the sequence generator 192 enables the differential driver 172 to place the data from bus 174 onto the cable 15. This same operation occurs in the B and C portions of the remote processor interface 32 such that the corresponding sequence generators and differential transmitters place the contents of the corresponding register, which matches, onto the cable 15 if the corresponding Exclusive Or circuit indicates a match. The sequence generator 192 also enables conventional differential transmitter 220 to transfer the output of the voter 216 to the parity bit line of the cable 15. The conventional differential receiver 222 provides parity of the data on cable 15 to the sequence generator 192. The sequence generator 192 compares the parity on the cable 15 with the internal parity for the data on bus 174, as generated by checker 216, and aborts the operation if there is disagreement.

For purposes of control flow, the remote processor functions are divided into local register read or write and memory read or write. Local registers are the control and status registers 196 and 198 and the memory address registers 176, 178, 180 and 182. Read and write accesses to the address of the data buffer registers 210 and 212 initiates memory reads or writes and are classified as remote functions.

Fig. 12 shows the states for a local register read where addresses bits A1 and A2, transferred from the host processor interface 30 of Fig. 4, specify the register to be read or written and the I/O Read/Write signal specifies the direction of data transfer. Master Sync and a clock rising edge from the control unit 118 of Fig. 4 causes the sequence generator 192 to begin. The sequence generator 192 goes through two states when it leaves the idle state 230. The first state 232 is to enable the low byte of the selected register onto the internal bus 174. The second state 234 is to enable the high byte onto the internal bus 174. During both states differential driver 172 will be enabled if the data of the register being read equals the data of a duplicate read register from another section. Data from at least two sections as shown in Fig. 9 will be compared and an output only occurs when agreement exists. The comparisons are done by circuit 156. Parity will be generated by voter 218.

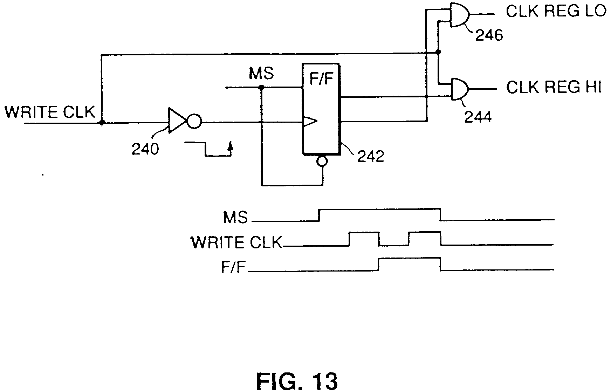

Local register writes transfer data from the host processor interface 30 via cable 15 to addressed registers in the remote processor interface 32. Data from the host processor interface are driven onto the internal bus 174 by receiver 170. The registers selected by address bits A2 and A1 are clocked one after the other to load the eight bit data into the two halves of a sixteen bit register. Fig. 13 shows the circuit used to produce the clock for the registers which is synchronous with the received data. This circuit includes an inverter 240, a flip flop 242 and two AND gates 244 and 246 which produce the signals also shown in Fig. 13.

Memory reads are triggered by reads of the data buffer register 210 and 212. Data buffer reads initiate a multibus II cycle which will read a memory on the bus. The address of the read must have been loaded with a prior write to the memory address registers 176-182. The semaphore check circuit 194 checks to determine if the address is in the semaphore range where the semaphore range is specified in the control and status register bits 5 and 6.

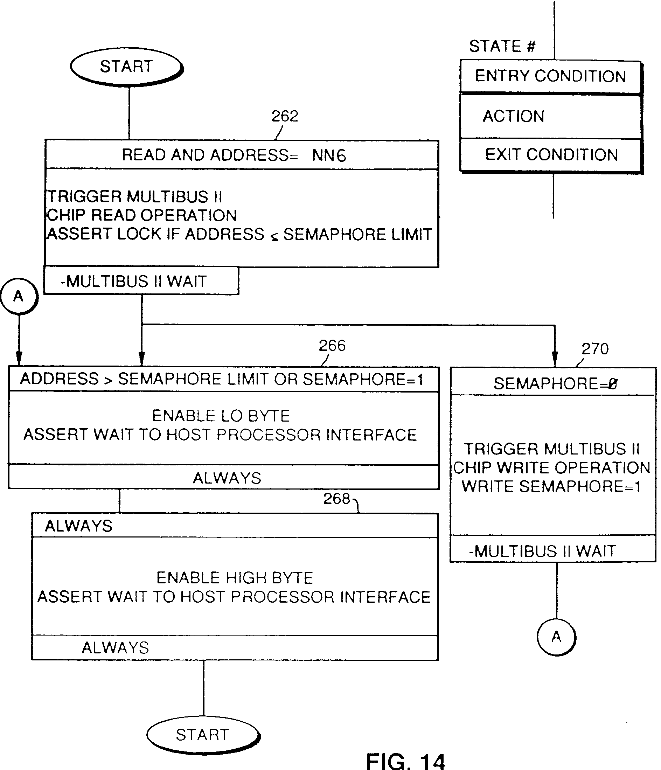

Fig. 14 shows the flow and major control signals for a memory read. The flow starts with a read of the address of the data buffer register. The sequence generator 192 will generate signals to cause the-conventional Multibus II control chip 214 to read memory. The sequence generator 192 will stay in this state until the Multibus II control chip 214 negates its wait signal. If the address is in the semaphore range a lock signal will be asserted to the Multibus II control chip. This will prevent another remote processor interface 30 from gaining access to the bus 42 until the semaphore can be set. A read in the semaphore range requires a write back of a one to the semaphore bit read if semaphore bit 15 is clear (zero). As a result, all other processes looking for a zero will see a one. The Multibus II control chip 214 will load the data read into the data buffer register 210 and 212. One of two processes 266 and 270 can now be followed in Fig. 14.

If the memory read was in the semaphore address range and a zero was read in the semaphore position of the data, the data word will be written back to memory 36 with the semaphore bit set. This is shown in Fig. 14. The Multibus II control chip 214 gates the address drivers 184, 186, 188 and 190 at proper time for this write back to occur. The flow states 266 and 268 complete a read by enabling the data onto the cable 15. The data buffer 210 and 212 will be enabled onto the internal bus 174 and driven by differential driver 272 provided circuit 156 detects a match.

A memory write is initiated by the computer 12 writing into the data buffer register 210 and 212. In this operation, the previously discussed local register write logic Fig. 11 loads the data buffer register 210 and 212 with the word to be written. The writing of the data buffer registers triggers the sequence generator 192 to initiate a Multibus II memory write. Wait will be asserted to the host processor interface 30 to hold off any further cycles until the write to memory is completed.

Interprocessor interrupts are interrupts wherein a computer 12 may cause an interrupt to another processor of its choice. The interrupts are done using the Multibus II message passing facility. The sending computer 12 initiates the interrupt by writing the port # (1-20) into its control and status register bits 4-0 along with an interrupt go bit. This is done by performing a local register write in the remote processor interface 32 where the timing is shown in Fig. 13. The sequence generator 192, on seeing the interrupt go bit, will signal the Multibus II circuit 214 to begin an interrupt transaction to the target remote processor interface 32. The target remote processor interface 32 will receive the interrupt message and then gate the received interrupt condition if the interrupt enable bit 15 of the target computer is set. If both interrupt and interrupt enable are true, interrupt pending (IP in Fig. 2d) will be set. The interrupt pending signal will be passed through driver 226 and cable 15 to the host processor interface of the target computer and to the ISA bus of the target computer. The target computer clears the interrupt pending condition by writing a zero to bit 15 of the control and status register.

The control unit 118 and sequence generator 192, as previously discussed, are preferably finite state machines which cycle through different states depending on the input signals. Such finite state machines can be implemented using discrete logic or programmable array logic or a microsequencer. The states of the finite state machines in host processor interface 30 and remote processor interface 32 have been discussed in detail and the programming of a suitable microsequencer, etc. can be accomplished by a person of ordinary skill in the art.

The many features and advantages of the invention are apparent from the detailed specification and thus it is intended by the appended claims to cover all such features and advantages of the invention which fall within the true spirit and scope of the invention. Further, since numerous modifications and changes will readily occur to those skilled in the art, it is not desired to limit the invention to the exact construction and operation illustrated and described, and accordingly all suitable modifications and equivalents may be resorted to, falling within the scope of the invention.

## Claims

1. A multiprocessor system, comprising:
repository means for storing a fault tolerant commonly accessible system state and data; and
computers connected to said repository means and each having access to said system state and data.

2. A system as recited in claim 1, further comprising a computer network connected to said computers.

3. A system as recited in claim 1, wherein said repository means comprises:
first through third memories each storing the system state and data and producing first through third outputs; and
an interface connected to said first through third memories and one of said computers and comparing the first through third outputs and producing a coincident output when at least two of the first through third outputs agree.

4. A system as recited in claim 3, further comprising a fault tolerant clock connected to said first through third memories and providing three synchronous outputs and including feedback means for preventing a single point of failure.

5. A system as recited in claim 3, wherein said interface comprises:
exclusive or means for comparing the first, second and third outputs and producing a coincident signal when one of the first and second outputs are coincident, or the second and third outputs are coincident or the first and third outputs are coincident; and
transmitter means for transmitting the coincident output responsive to the coincident signal.

6. A system as recited in claim 5, wherein said first through third outputs include corresponding parity outputs and said interface further comprises parity voting means for voting on the corresponding parity outputs and producing a parity output when at least two of the corresponding parity outputs agree.

7. A system as recited in claim 3, wherein said repository means includes triplicated interrupt passing means for passing triplicated interrupts and said interface includes means for voting on the triplicated interrupts.

8. A system as recited in claim 4, wherein said fault tolerant clock comprises first through third oscillator circuits connected to each other via feedback paths synchronizing oscillation.

9. A system as recited in claim 3, wherein said interface comprises interrupt means for signalling an interrupt between said computers.

10. A method of producing a fault tolerant output, comprising:
(a) reading first through third outputs from first through third memories;
(b) performing an exclusive or operation on pairs of the first through third outputs to determine coincidence of the first through third outputs; and
(c) producing the fault tolerant output upon the coincidence of one of the pairs of the first through third outputs.
